# EUROPEAN PATENT SPECIFICATION

(11) **EP 2 981 990 B1**
(45) Date of publication and mention of the grant of the patent: **07.06.2017**
(21) Application number: 14716750.6
(22) Date of filing: 02.04.2014
(51) Int. Cl.: H01L 35/30, B60H 1/22, F23L 15/04, B60H 1/00

(54) **PORTABLE AIR HEATING SYSTEM**
TRAGBARES LUFTHEIZUNGSSYSTEM
SYSTÈME PORTABLE DE CHAUFFAGE D'AIR

(30) Priority: 03.04.2013 DK 201370183; 29.10.2013 DK 201370630
(43) Date of publication of application: 10.02.2016
(73) Proprietor: Entiffic ApS, 9530 Støvring (DK)
(72) Inventor: VESTERGÅRD MORTENSEN, Paw, DK-9800 Hjørring (DK); ASGHAR ENKESHAFI, Ali, DK-9200 Aalborg SV (DK)
(74) Representative: Høyer, Michael
(86) International application number: PCT/DK2014/050078
(87) International publication number: WO 2014/161551

(56) References cited:
- EP-A1- 1 571 718
- WO-A2-2006/103613
- US-A- 3 056 848
- US-A- 3 150 656
- US-A- 3 269 873
- US-A- 3 428 496
- US-A- 3 777 975
- US-A- 5 974 803
- US-B1- 6 527 548

## Description

### FIELD OF THE INVENTION

The present invention relates to a Portable Air Heating System (PAHS).

### BACKGROUND OF THE INVENTION

A traditional portable heating system is a small unit that blows heated air. The unit is always connected to an electrical power source for operation. This electrical power source can be the external grid or a battery.

In some cases portable heating systems are coupled to electricity generator so that can operate as stand-alone systems. For example, portable heating systems may have an integrated fuel tank and a power generator so as to power the system.

Portable heating systems require to be light weight so that can be easily transported and handled. Portable heating systems may be used for climate comfort or in extreme climate conditions where heat is needed, for example cabin of a vehicle, boat cabin, tents or engine of a vehicle in extreme cold climate.

Any application of portable heating systems works following the same general concept. Means for forcing air though a heat generator are used so that hot air is produced. To power these means and to produce heat, electrical power is needed, thus portable heating systems need to be connected to an electrical power source as a car battery, power generator or grid power.

The main electrical consumption in these systems depends on the fuel injection system/fuel atomisation pressure, spark system and the air fan/air blower. Because of the high electrical consumption the commercial availability of these portable heating systems is rather limited. In particular, due to the high electrical consumption it is not possible to operate a standard portable heating system using a car battery as power source since after few hours of use the battery becomes completely depleted.

Accurate use of vehicle batteries is particularly relevant in electric vehicle. In these vehicles, cabin heating cannot be produced by electrical heating as this would cause complete depletion of the batteries within few hours.

For these reasons alternative solutions to keep small areas heated are currently used. For example, most of the truck drivers who stop their vehicles on resting areas during the night to get rest/sleep let the engines of their vehicles running in order to use the heat from the engine to heat the cabin.

This solution causes an increase of pollution and reduces the total fuel efficiency as the use of the engine for heating is rather inefficient.

Furthermore this solution is not possible in all-electric or battery electric vehicles (BEVs) where no internal combustion engine is present.

Alternatively a small diesel heating system can be installed in the cabin of the vehicle avoiding running noisy engine and getting a better heat efficiency, e.g. between 65-70% from the fuel. This solution has the drawback that a separate battery is needed to supply enough electrical power and avoid that the battery of the vehicle gets depleted. However, even in this case, after a couple of hours of use the separate battery for the portable heating system needs to be recharged. The recharging of the battery can be obtained at the expense of the vehicle battery. Indeed under driving conditions the vehicle generator will have to use part of the power from engine, i.e. more fuel consumption, to charge in turn the separate battery of the portable heating system.

US3150656 discloses a heater for use in a vehicle, including a burner, a heat exchanger and thermoelectric elements. A plurality of such thermoelectric elements are arranged in series on the outer surface of the heater combustion chamber to produce an electric current.

Thus, there is a need for an independent and efficient cabin heating system in particular for electrical vehicles, which does not make use of the internal batteries of the vehicles.

Hence, an improved portable heating system would be advantageous, and in particular a more efficient and/or reliable PAHS would be advantageous.

### OBJECT OF THE INVENTION

It is an object of the invention to provide a more efficient, reliable and less expensive PAHS.

It is an object of the invention to provide a PAHS having lower running cost than known portable heating systems.

It is a further object of the present invention to provide an alternative to the prior art.

In particular, it may be seen as an object of the present invention to provide a PAHS that solves the above mentioned problems of the prior art without having to be interfaced to the battery of the vehicle in which it is installed.

### SUMMARY OF THE INVENTION

Thus, the above described object and several other objects are intended to be obtained in a first aspect of the invention by providing a portable air heating system (PAHS) according to claim 1 and comprising: a PAHS air inlet; a burner connected to the PAHS air inlet, the burner comprising a fuel inlet for introducing fuel to the burner, a combustion blower for blowing air from an air inlet into the burner, thereby allowing for combustion of the fuel, and a burner air outlet for releasing heated air and exhaust gas from the burner; a first heat exchanger for producing electricity wherein heat is exchanged between the heated air and elements of the first heat exchanger; means for blowing air from the PAHS air inlet towards the first heat exchanger.
In some embodiments the PAHS according to the first aspect of the invention further comprisies: a second heat exchanger for increasing the temperature of air entering the PAHS air inlet; and wherein the means for blowing air from the PAHS air inlet towards the first heat exchanger are means for blowing air from the PAHS air inlet towards the first heat exchanger and the second heat exchanger.
The air inlet from which air is blown by a combustion blower into the burner may be the PAHS air inlet or another air inlet or chamber.
The means for blowing air may be, for example a fan or a blower.
The fuel may be any substance such as oil, gasoline, gas, or coal that produces heat or power when it is burned. The fuel may be in its liquid, gas or solid form. The PAHS of the invention has several advantages compared to the available heaters on the market.
For example, the PAHS of the invention has very low electrical power consumption and a high efficiency because of its simple design and optimized used of the safe electronic control system together with the utilization of the waste heat from its exhaust. The power consumption of the PAHS of the invention is about 7-9 Watt per kW heated air. This low electrical consumption allows the PAHS of the invention to be supplied by its own power generator.
Commercially available portable heaters/vehicle heaters have an electrical consumption of about 20-25 Watt per each kW heated air depending on the different systems. Commercial available portable heaters do not integrate a power generator to cover the electrical need of the system.
Another advantage of the PAHS is the presence of at least two heat exchangers. In addition the first heat exchanger is also a solid state power generator. The electrical power produced by the first heat exchanger/generator may be used partly for covering the electrical needs of the PAHS; partly for charging the battery of the vehicle, if the heater is mounted in a vehicle, such as a truck; and partly for charging its own integrated battery.
The second heat exchanger located downstream to the first heat exchanger is used to absorb most of the heat that was not absorbed by the first heat exchanger.
Commercially available portable heaters/vehicle heaters have only one heat exchanger.
PAHS has very high fuel efficiency as heat absorption is optimized by the use of at least two heat exchangers. Furthermore, the PAHS of the invention does not use electrical power from an external battery, e.g. the battery of the vehicle where it has been installed, therefore the vehicle do not use extra fuel to charge the battery. In general, a depleted battery "cost" fuel to be recharged and the fuel efficiency for charging a battery is very low, e.g. about 20%.
Commercial available portable heaters/vehicle heaters on the contrary do not have integrated double stage heat exchangers or any integrated electrical power supply that can continuously cover the electrical demand of the system.
A further advantage of the PAHS of the invention is a unit without any external wires. It can be mounted in a vehicle and/or moved to other vehicles or small areas such as a camping tent providing heat and electricity when needed. Thus, the PAHS of the invention has a very high degree of transportability.
For example the PAHS of the invention may be adapted to be installed in a truck cabin. The PAHS of the invention may be also adapted to be installed or integrated into a all-electric vehicles such as BEVs, plug-in hybrid vehicles, (PHEVs), electric vehicle conversions of hybrid electric vehicles and conventional internal combustion engine vehicles.
The function of the first heat exchanger is to produce electricity and heat the air flowing through its elements.
Thus in some embodiments the first heat exchanger is a thermoelectric power generator, thus comprising thermoelectric modules, i.e. components such as thermoelectric p- and n-type semiconductor legs, slices, elements or discs of any shape, or any modules with integrated p- and n-type semiconductor legs; components all referred herein as thermoelectric modules.
In some embodiments the first heat exchanger may also have the function of increasing the temperature of air entering the PAHS air inlet.

In some embodiments the first heat exchanger comprises: a first heat exchanger air inlet tube for heated air, the first heat exchanger air inlet tube connected to the burner air outlet; a first heat exchanger air outlet tube; and a first heat exchanger body.
The first heat exchanger air inlet tube is adapted to allow the hot air and exhaust originated in the burner to flow through the exchanger and exchange heat with the elements of the first heat exchanger.
The connection between the first heat exchanger air inlet tube and the burner air outlet may be referred as fluid connection, thus to allow a fluid, such as air or hot gases to flow from the burner to the inlet tube.
When hot air flows from the burner air outlet to the first heat exchanger air inlet tube, the heat is transferred to the tube and thus to the body of the first heat exchanger.
Thus "in operation" may be defined as when hot air or hot gases flow through the first heat exchanger.
In some embodiments the first heat exchanger body comprises thermoelectric modules, thereby produces electricity when in operation.
In some embodiments the first heat exchanger body is located around the burner air outlet or around the first heat exchanger air inlet tube.
In this way heat can be exchanged between the hot air/exhaust from the burner with the first heat exchanger body and in turn with its elements leading to the temperature gradient across the thermoelectric modules, such as square P and N slices or modules with integrated p- and n-type semiconductor legs, in contact with the heat exchanger elements necessary to produce electricity.
In some further embodiments the first heat exchanger body comprises: air cooled elements; heat elements; and the thermoelectric square slices or modules located in between and in contact with the air cooled elements and the heat elements. Air cooled elements and heat elements may be referred to as first heat exchanger elements.
The thermoelectric modules may be any commercial thermoelectric modules, i.e. commercial available components such as thermoelectric p- and n-type semiconductor legs, slices, elements or discs of any shape, or any commercial available modules with integrated p- and n-type semiconductor legs.

In some further embodiments the heat elements and the air cooled elements have a first portion in contact with at least one of the thermoelectric square slices or modules wherein a surface of the first portion in contact with the at least one of the thermoelectric square slices or modules has an inclination in the range between 1 and 45 degrees in respect to a surface of a second portion of the heat elements and of the air cooled elements.
In some embodiments the surfaces of the first portion of the heat elements and of the air cooled elements have an inclination in the range between 0.1 and 90 degrees in respect to the surfaces of a second portion of the heat elements and of the air cooled elements.
In some further embodiments the surfaces of the first portion of the heat elements and of the air cooled elements have an inclination in the range between 1 and 25 degrees in respect to the surfaces of a second portion of the heat elements and of the air cooled elements.
In some embodiments the inclination of the first portion of the heat elements is complementary to the inclination of the first portion of the air cooled elements. The angle of inclination is defined as the angle between a reference plane, i.e. the one of the first portion in contact with the thermoelectric modules and another plane or axis of direction determined by the second portion not in contact with the thermoelectric modules.
Complementary is herein used in relation to its geometrical definition. Complementary angles are two angles that when their measurements are added together is equal to 90 degrees.
The first heat exchanger is described herein as an air cooled system however in some other embodiments the first heat exchange system may be a water/air system or a water cooled system.
The first heat exchanger, which is also the power generator of the system, may be produced by assembling single rings consisting of assembled components.
Each component comprises at least an air cooled element, an heat element and thermoelectric modules located in between and in contact with a portion of the surface of the correspondent air cooled element and heat element.
When in operation the heat elements are heated by the passage of hot air, exhaust and flame produced by the burner into the burner pipe or combustion chamber of the heat exchanger body that is in contact with at least part of the heat elements. Air cooled elements are cooled by the air blowing in between the air cooled elements forced in contact with these elements by the main air fan. The difference in temperature between the air cooled elements and the heat elements generates a temperature gradient across the thermoelectric modules that triggers the generation of electricity.
The particular ring shape is achieved through the design of its components. In each component, the heat elements and the air cooled elements have a first portion, in contact with the thermoelectric modules having a certain degree of inclination in respect to a surface of a second portion of the heat elements and of the air cooled elements. The second portion is the portion of the heat elements and of the air cooled elements which is not in direct contact with the thermoelectric modules.
The inclination of the first portion of the heat element is complementary to the inclination of the first portion of the air cooled element. As the thermoelectric modules have straight and not inclined surfaces, the inclination of the elements allows for the formation of curved components that can be assembled into a circular heat exchanger.

In some embodiments the second heat exchanger is located downstream to the first heat exchanger.
In some embodiments the function of the second heat exchanger is to produce electricity and heat the air flowing through its elements.Thus in some embodiments the second heat exchanger is a thermoelectric power generator, thus comprising thermoelectric modules, i.e. components such as thermoelectric p- and n-type semiconductor legs, slices, elements or discs of any shape, or any modules with integrated p- and n-type semiconductor legs. These thermoelectric modules may be commercial thermoelectric modules.

In some embodiments the second heat exchanger comprises: a second heat exchanger air inlet tube for heated air, i.e. hot air, the second heat exchanger air inlet tube connected to the first heat exchanger air outlet tube; a body comprising air cooled parts, the body surrounding at least part of the second heat exchanger air inlet tube for heated air; and a second heat exchanger air outlet tube. The second heat exchanger may be an air cooled heat exchanger or a water/air or water cooled heat exchanger.

In some embodiments the air cooled parts of the body of the second heat exchanger are fins increasing the surface area of the body and thus leading to an improved heat exchange.
In operation combusted fuel and air from the first heat exchanger will be fed to the air inlet tube of the second heat exchanger. The combusted hot gas will flow into an inner tube, i.e. an open chamber surrounding at least part of the second heat exchanger air inlet tube.
Thus in some further embodiments the body of the second heat exchanger further comprises at least an open chamber surrounding at least part of the second heat exchanger air inlet tube.
In some further embodiments the body of the second heat exchanger is configured so that the air entering the second heat exchanger air inlet tube is forced through a confined space between an internal surface of the at least one open chamber and an external surface of the second heat exchanger air inlet tube.
Thus, following the flow path defined by the internal structure of the second heat exchanger, the hot gases will swirl back through the gap, that is the confined space between an internal surface of the inner tube, i.e. the open chamber surrounding at least part of the second heat exchanger air inlet tube, and an external surface of the outer tube, i.e. the second heat exchanger air inlet tube. The hot gases will then turn again forward through the gap between the outer tube and the second heat exchanger body, leading towards the outlet/exhaust tube of the second heat exchanger.
Indeed, the heated air entering the second heat exchanger air inlet tube is allowed to flow though the tube into an open chamber of the body and forced to pass through the confined space between at least part of the external surface of the second heat exchanger air inlet tube and at least part of an internal surface of the at least one open chamber.
The second heat exchanger approximately may transfer 80% of the heat entering the heat exchanger through its inlet.

In some embodiments according to the first aspect of the invention the PAHS further comprises a third heat exchanger for producing electricity, the third heat exchanger connected to the second heat exchanger. For example, the third heat exchanger may be fluidly connected to the air outlet tube of the second heat exchanger.
The third heat exchanger can keep the engine warm during its operation, i.e. when the engine of the vehicle is turned off to eliminate idling, cold starts and thus reduce the fuel consumption of the engine.
The third heat exchanger may be mounted on the side of the oil pan under the engine body to keep the engine warm when the driver turn off the engine and start the PAHS.
In some further embodiments the third heat exchanger is a flue gas tube for generation of thermoelectric power. The flue gas tube may comprise: an inner portion having an internal and external surface, the inner portion having thermoelectric modules located on the external surface; an outer portion having an internal and external surface, the outer portion surrounding the inner portion; means for transferring heat between the thermoelectric modules and the outer portion.
In some embodiments the flue gas tube comprises a fan. The electricity produced by the flue gas tube may be used to power the fan.
In operation a flow of exhaust gas /flue gas, from the second heat exchanger through an insulated flexible tube, enters the third heat exchanger through the inlet tube. The flue gas tube of the third heat exchanger may be a double tube with a gap between the outer wall of the inner tube and the inner wall of the outer tube, where thermoelectric modules are located. The air blown by the fan through the gap cools down the outer surface of the inner tube. The inner tube works as a thermoelectric generator as it contains thermoelectric elements. The fan continuously sends cold air to the third heat exchanger, thus the air is heated and the warm air is blown to the oil pan of the engine.
In some embodiments the thermoelectric elements of the flue gas tube have a first side facing the external surface of the first or inner portion and have a second side facing the internal surface of the second or outer portion.
The second side of the thermoelectric elements of the flue gas tube may be opposite to the first side of the thermoelectric elements of the flue gas tube.
The thermoelectric elements of the flue gas tube may be distributed around the external surface of the first or inner portion.
The first side of the thermoelectric elements of the flue gas tube may follow the outline of the external surface of the first or inner portion.

The first or inner portion may have a circular cross section.
In some embodiments the first or inner portion has a polygon cross section.
The first or inner portion may be adapted to be heated by a flue gas flow, the flue gas flowing in close contact with the internal surface of the first or inner portion. The second or outer portion may be adapted to be cooled by a flow of fluid, such as water in contact with the external surface of the second or outer portion.
In some embodiments the first or inner portion and the second or outer portion are hermetically sealed, thereby no physical contact between the fluid flowing inside the first or inner portion and the fluid flowing outside the second or outer portion is present.
The internal surface of the second or outer portion may comprise the means for transferring heat. For example the means for transferring heat may be metal capes.
In some further embodiments the at least one of the end parts of the flue gas tube for generation of thermoelectric power is characterized by the absence of the first or inner portion.
The external diameter of the flue gas tube may be substantially the same along its entire length.

In some further embodiments the PAHS according to the first aspect of the invention is adapted to be inserted in a vehicle engine, for example to be located in the engine of a truck.
The PAHS according to the first aspect of the invention may further comprise a fuel tank.
The fuel tank may be physically connected to the PAHS.
In some embodiments the fuel tank may be also physically detached from the PAHS.
In some embodiments the PAHS is adapted to connect a fuel tank.
In some embodiments the fuel tank is integrated in the PAHS.
In some embodiments the fuel tank is a gas container or a gas bottle, such as a LPG bottle.
A gas container may be any container for a fuel that at atmospheric pressure is in the form of gas. However this fuel may be in the liquid form, when contained into the container, due to the increased pressure inside the container.

A further advantage of the PAHS of the invention when fuelled by a gas bottle is that the system provides about 30% more electrical power than its oven consumption. This means that the system becomes a 100% self powering system and provides 30% surplus power for changing or lighting porpuse.

The first and other aspects and embodiments of the present invention may each be combined with any of the other aspects and embodiments. These and other aspects of the invention will be apparent from and elucidated with reference to the embodiments described hereinafter.

### BRIEF DESCRIPTION OF THE FIGURES

The PAHS according to the invention will now be described in more detail with regard to the accompanying figures. The figures show one way of implementing the present invention and is not to be construed as being limiting to other possible embodiments falling within the scope of the attached claim set.
Figure 1A is a schematic drawing of a PAHS according to some embodiments of the invention.
Figure 1B is a schematic drawing of a PAHS according to some other embodiments of the invention.
Figure 2 is a top view of a PAHS according to some embodiments of the invention.
Figure 2A is a top view of a PAHS according to some other embodiments of the invention, where the fuel used is in its gas form.
Figure 3 is a schematic view of a burner according to some embodiments of the invention.
Figure 3A is a schematic view of a burner according to some embodiments of the invention, where the fuel used is in its gas form.
Figure 4 is a schematic drawing of a PAHS according to some embodiments of the invention comprising the third heat exchanger.
Figure 4A shows an exploded view drawing of the different components of PAHS according to some embodiments of the invention where a gas can be used as fuel.
Figure 5A is a schematic view of an air cooled heat exchanger according to some embodiments of the invention.
Figure 5B is a schematic view of an air cooled heat exchanger according to some other embodiments of the invention.
Figure 6 is a schematic view of another air cooled heat exchanger according to some embodiments of the invention.
Figure 7 is a cross section of the air cooled heat exchanger of figure 6 according to some embodiments of the invention.
Figure 8 shows different views and cross sections of a flue gas heat exchanger according to some embodiments of the invention.
Figure 9 shows a schematic drawing of PAHS designed to be used in its standing position.
Figure 10 shows a schematic drawing of PAHS designed to be used in its lying, ie.
orizontal position.
Figure 11 and 12 show a PAHS adapted to be used for heating materials, such as cooking food according to some embodiments of the invention.
Figure 13 shows a PAHS 300 adapted to be used for heating materials, such as cooking food, according to some embodiments of the invention.

### DETAILED DESCRIPTION OF AN EMBODIMENT

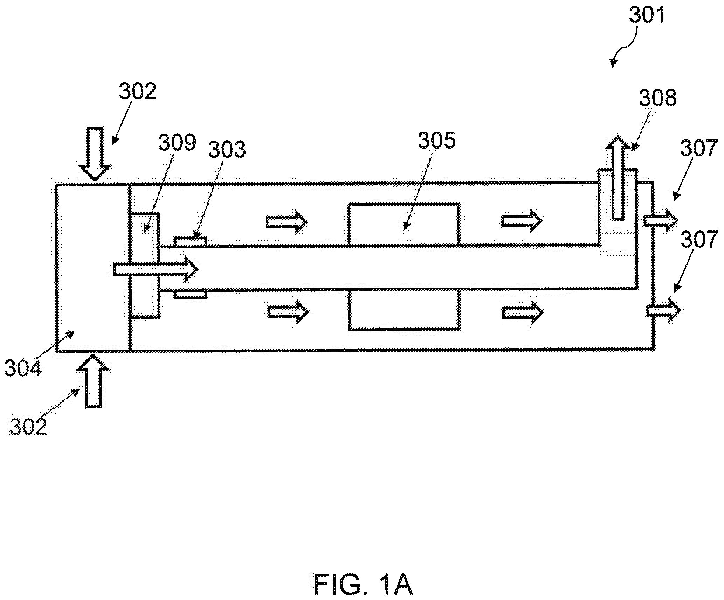

Figure 1A is a schematic drawing of a PAHS according to some embodiments of the invention. The PACS 301 comprises one or more air inlet 302, a burner 303 connected to the air inlet 302 via an air inlet chamber 304; a first heat exchanger 305 for producing electricity; one of more air outlet 307 to diffuse warm air in the vicinity of the PAHS 301; an exhaust outlet 308 to allow the release of the exhaust from the burner to the outside environment or towards a third heat exchanger.
When in operation fuel is pumped towards the burner 303 though piping (not shown) and air is allowed to enter the PAHS via air inlet 302. Part of this air is directed towards the burner 303 via a burner air blower (not shown). Most of the air entering the air inlet 302 is blown towards the first heat exchanger 305 by a main air fan 309. The main air fan 309 and the burner air blower may be mechanically independent as well as independently powered. This configuration has the great advantage that the air flux can be optimized depending on the need of the PAHS. For example at start the main air fan 309 does not need to blow air to be heated by the first and second heat exchanger as these exchangers are not hot as the burner has not started yet or have been just started. The burner air blower on the contrary needs to blow air inside the burner so as to start the burner and produce heat. Thus the speed and the need of the fan 309 and the burner air blower are quite different and the detachment of their operability optimizes their function and reduces the electricity and fuel consumption. For example, when the heat exchangers are hot, the burner can be stopped, i.e. the burner air blower can also stop, while the main air fan 303 needs to blow continuously so as to take advantage of hot heat exchangers and thus producing hot air that is released via hot air outlet 307.
The fuel used may be in the liquid, gas or solid form.

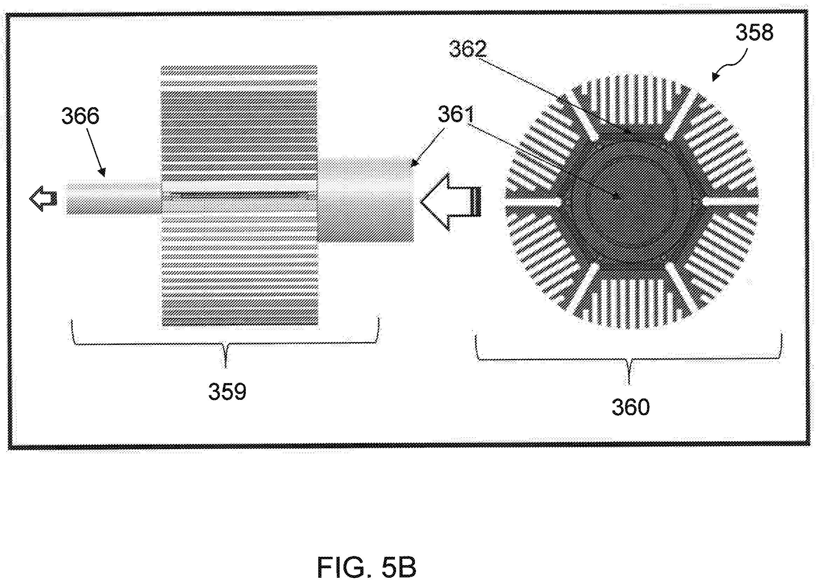

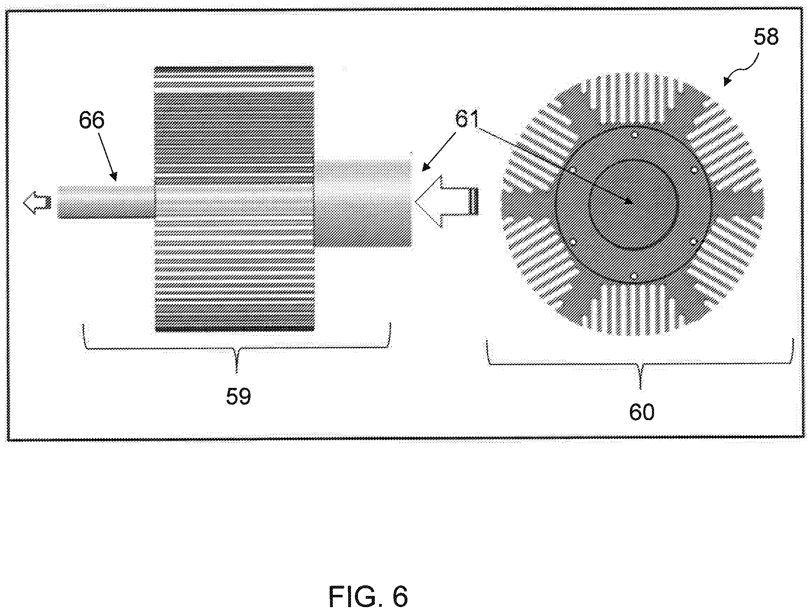

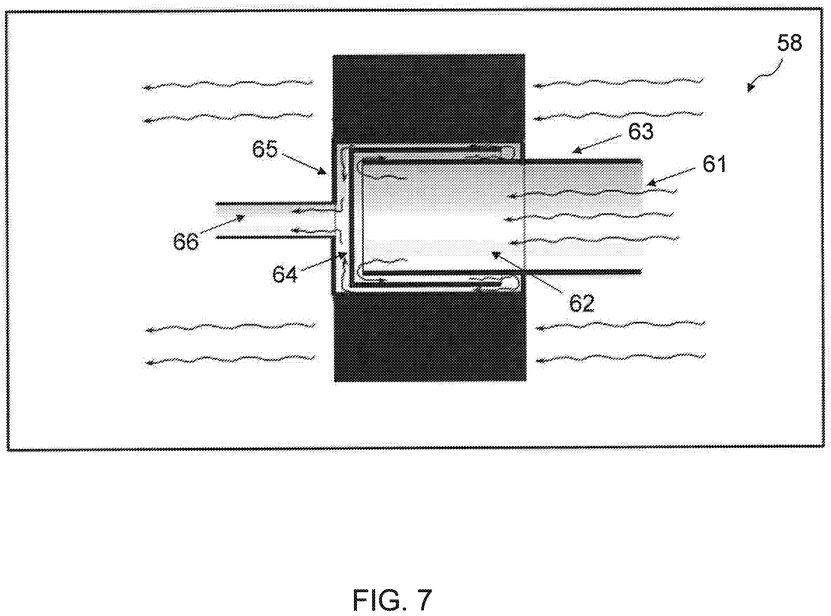

In some embodiments the first heat exchanger 305 may comprise a first heat exchanger air inlet tube for heated air, the first heat exchanger air inlet tube connected to the burner air outlet; a body comprising air cooled parts the body surrounding at least part of the first heat exchanger air inlet tube for heated air; and a first heat exchanger air outlet tube.
In some embodiments the body and the air cooled parts of the body of the first heat exchanges may be the same as the one shown for the second heat exchanger as in figure 6 and figure 7.
However, when the body and the air cooled parts of the body shown in figure 6 and 7 are the one of the first heat exchanger, thermoelectrics elements or thermoelectrics modules are located between the air cooled elements and the external surface of the inner tube 62 or the outer tube 64 or the external surface of the heat exchanger body, thus between the body and the air cooled parts in order to produce electricity.
In some embodiments the body and the air cooled parts of the body of the first heat exchanges may be the same as the one shown in figure 5B.

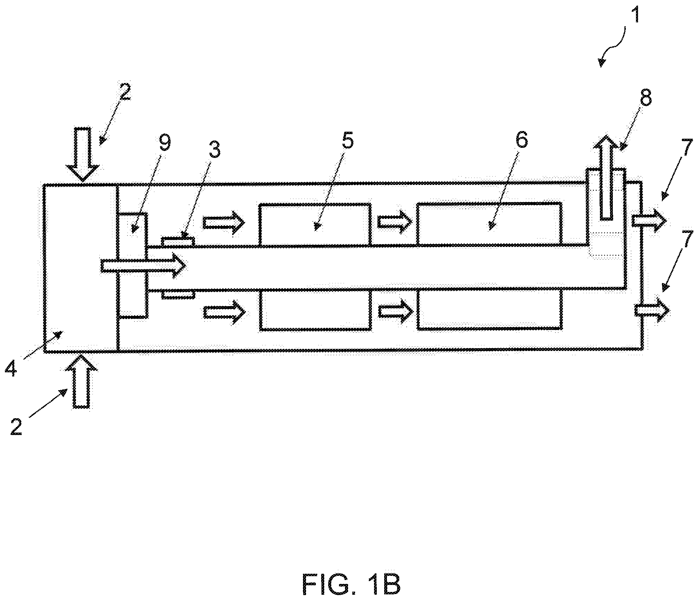

Figure 1B is a schematic drawing of a PAHS according to some embodiments of the invention. The PACS 1 comprises one or more air inlet 2, a burner 3 connected to the air inlet 2 via an air inlet chamber 4; a first heat exchanger 5 for producing electricity; a second heat exchanger 6 for increasing the temperature of the air entering the PAHS 1; one of more air outlet 7 to diffuse warm air in the vicinity of the PAHS 1; an exhaust outlet 8 to allow the release of the exhaust from the burner to the outside environment or towards a third heat exchanger.
When in operation fuel is pumped towards the burner 3 though piping (not shown) and air is allowed to enter the PAHS via air inlet 2. Part of this air is directed towards the burner 3 via a burner air blower (not shown). Most of the air entering the air inlet 2 is blown towards the first heat exchanger 5 by a main air fan 9. The main air fan 9 and the burner air blower may be mechanically independent as well as independently powered. This configuration has the great advantage that the air flux can be optimized depending on the need of the PAHS. For example at start the main air fan 9 does not need to blow air to be heated by the first and second heat exchanger as these exchangers are not hot as the burner has not started yet or have been just started. The burner air blower on the contrary needs to blow air inside the burner so as to start the burner and produce heat. Thus the speed and the need of the fan 9 and the burner air blower are quite different and the detachment of their operability optimizes their function and reduces the electricity and fuel consumption. For example, when the heat exchangers are hot, the burner can be stopped, i.e. the burner air blower can also stop, while the main air fan 3 needs to blow continuously so as to take advantage of hot heat exchangers and thus producing hot air that is released via hot air outlet 7. The fuel used may be in the liquid, gas or solid form.

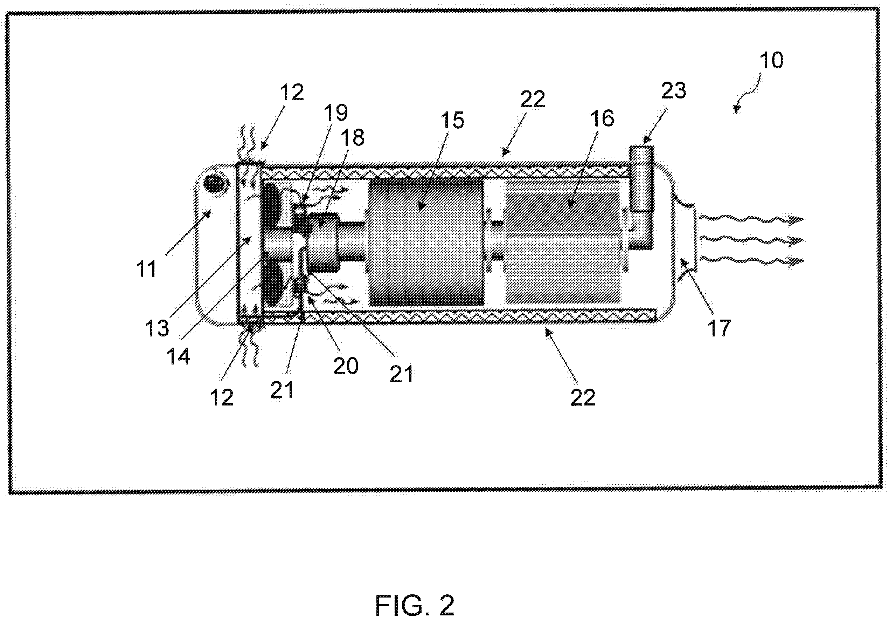

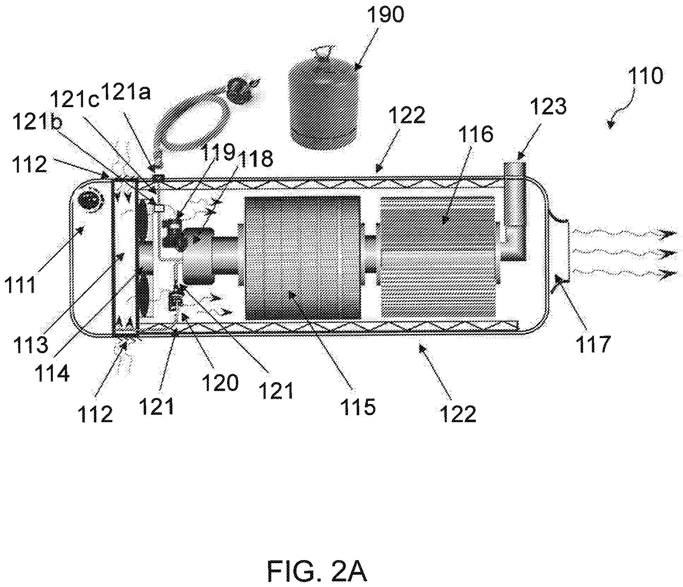

Figure 2 is a top view of a PAHS 10 according to some embodiments of the invention comprising the optional fuel tank 11. Figure 2 shows PAHS 10 comprising air intake louvers 12 allowing air to enter the air intake chamber 13. When in operation, the air in the air intake chamber 13 is blown via the main air fan 14 inside the PAHS 10 from the air intake chamber 13 towards the first heat exchanger 15 and towards the second heat exchanger 16 so as to produce warm air to be released into the vicinity of the PAHS 10 via air outlet duct 17. Part of the air present in the air intake chamber 13 is blown into the burner head 18 via a burner air blower 19. A flue pump 20 ensures that fuel from the fuel tank 11 is pumped into the burner head 18 via piping 21. Isolation 22 is present all around the PAHS 10 to avoid leak of heat into the outside environment. Heated air and exhaust from the burner exchange heat with the first heat exchanger 15 and the second heat exchanger 16 and leaves the PAHS 10 via exhaust outlet 23.

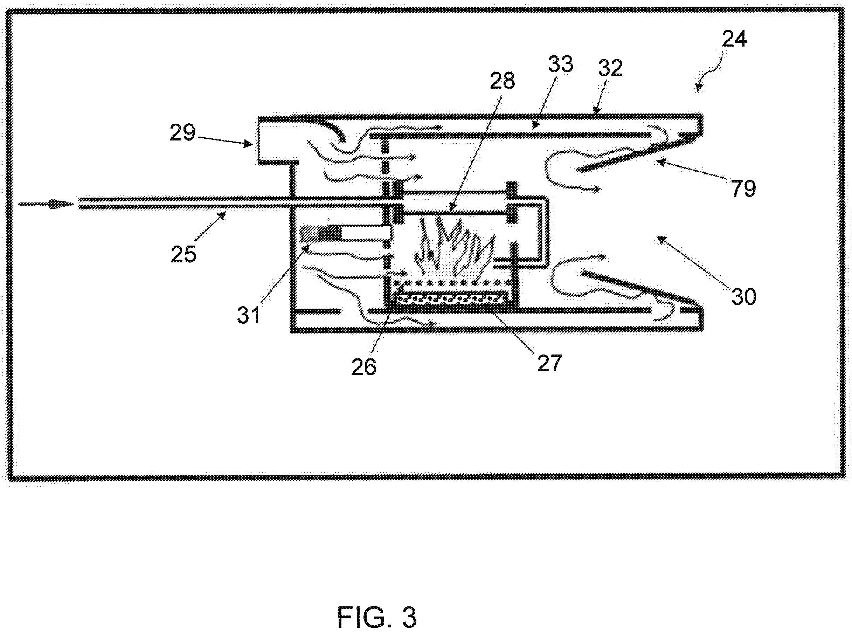

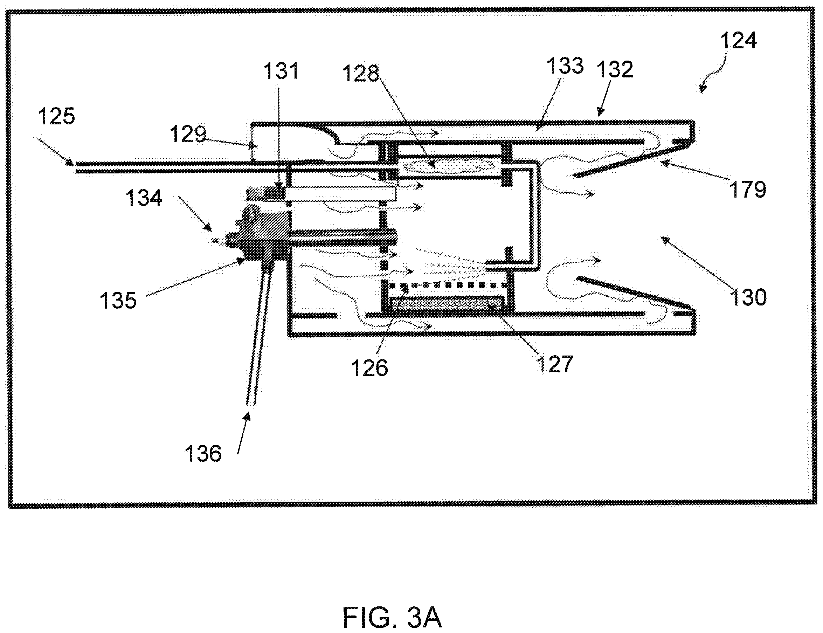

Figure 3 is a schematic view of a burner 24 according to some embodiments of the invention.
Figure 3 shows burner 24, i.e. a double-walled straight pipe of Inconel alloy with a fuel injection tube 25, an electric glow wire mesh 26, glass wool 27 and a fuel evaporator 28, a flame sensor 31, a combustion air inlet 29 where air enters the burner blown by the burner air blower (not shown) and a flame outlet 30 to release exhaust and heated air towards the heat exchangers.
In operation the burner 24 is firstly started: the electric glow wire mesh 26 receives electrical power and start to glow. The fuel via fuel injection tube 25 is injected onto the glowing wire mesh 26 and also dropped partly onto the glass wool 27. The burner air blower begins to add the necessary volume of air for combustion. The fuel over the mesh 26 and dropped on glass wool 27 ignites. The flame sensor 31 senses the glowing from the flame and switch off the electric power to the glowing wire mesh. The flame from dropped fuel on glass wool superheats and evaporates the fuel in the fuel evaporator. Evaporated hot gas injects in the start flame and burns in the present of air, so that the burner 24 will run continuously.
In continuous operation the inner wall of the burner 24 will be heated. Part of the air inlet is pre heated while crossing between the burner outer wall 32 and the burner inner plate 33.
The burner 24 comprises also a back plate, or air swirled plate 79 that forces the air to swirl with the effect of concentrating the flame in the centre of the burner flame outlet 30.The burner is designed so that most of the hot gases will be burned at the flame outlet, which means that most of the hot gases will be burned in the first heat exchanger, i.e. the power generator. An electronic control system (not shown) adjusts the volume of the combustion air and the metering of the fuel in any condition.
Programed control electronics may control the burner under operation.
The burner is controlled by the flame sensor 31, fuel pump/metering pump (not shown), temperature sensor (not shown) and the combustion air blower not shown).
Figure 2A is a top view of a PAHS 110 according to some embodiments of the invention when the fuel used may be also be in the form of gas. Figure 2A shows PAHS 110 comprising air intake louvers 112 allowing air to enter the air intake chamber 113. When in operation, the air in the air intake chamber 113 is blown via the main air fan 114 inside the PAHS 110 from the air intake chamber 113 towards the first heat exchanger 115 and towards the second heat exchanger 116 so as to produce warm air to be released into the vicinity of the PAHS 110 via air outlet duct 117. Part of the air present in the air intake chamber 113 is blown into the burner head 118 via a burner air blower 119. When a source of gas, such as a LPG gas bottle 190, is not connected to the gas fuel connection 121a and then the flue pump 120 ensures that fuel from the fuel tank 111 is pumped into the burner head 118 via piping 121.
When a source of gas, such as a LPG gas bottle 190 is connected to the gas fuel connection 121a, the gas fuel flows into the burner head 118 via a valve, such as a solenoid valve 121b and the piping 121c.
Isolation 122 is present all around the PAHS 110 to avoid leak of heat into the outside environment. Heated air and exhaust from the burner exchange heat with the first heat exchanger 115 and the second heat exchanger 116 and leaves the PAHS 110 via exhaust outlet 123.
Figure 3A shows burner 124, i.e. a double-walled straight pipe of Inconel alloy with a liquid fuel injection tube 125, a LPG gas fuel injection tube 136, an electric glow wire mesh 126, an ignition spark plug 134, primary air and gas fuel mixer 135, glass wool 127 and a fuel evaporator 128, a flame sensor 131, a combustion air inlet 129 where air enters the burner blown by the burner air blower (not shown) to release exhaust and heated air towards the heat exchangers and a flame outlet 130.
In operation by liquid fuel the burner 124 is firstly started: the electric glow wire mesh 126 receives electrical power and start to glow. The fuel via fuel injection tube 125 is injected onto the glowing wire mesh 126 and also dropped partly onto the glass wool 127. The burner air blower begins to add the necessary volume of air for combustion. The fuel over the mesh 126 and dropped on glass wool 127 ignites. The flame sensor 131 senses the glowing from the flame and switch off the electric power to the glowing wire mesh. The flame from dropped fuel on glass wool superheats and evaporates the fuel in the fuel evaporator. Evaporated hot gas injects in the start flame and burns in the present of air, so that the burner 124 will run continuously.
In operation by LPG gas fuel the burner the burner 124 is firstly started: the spark plug 134 receive high voltage electrical power from the electronic ignition system and start to ignite. The LPG fuel via fuel tube 136 will be mixed with air in the primary gas-air mixer 135. The burner air blower begins to add the necessary volume of air for combustion and the burner 124 will run continuously. The flame sensor works as mentioned before.
In continuous operation the inner wall of the burner 124 will be heated. Part of the air inlet is pre heated while crossing between the burner outer wall 132 and the burner inner plate 133.
The burner 124 comprises also a back plate, or air swirled plate 179 that forces the air to swirl with the effect of concentrating the flame in the centre of the burner flame outlet 130.The burner is designed so that most of the hot gases will be burned at the flame outlet, which means that most of the hot gases will be burned in the first heat exchanger, i.e. the power generator. An electronic control system (not shown) adjusts the volume of the combustion air and the metering of the fuel in any condition.

Programed control electronics may control the burner 124 under operation.
By operation with liquid fuel the burner 124 is controlled by the flame sensor 131, fuel pump/metering pump (not shown), temperature sensors (not shown) and the combustion air blower not shown).
By operation with LPG gas fuel the burner is controlled by the flame sensor 131, Fuel solenoid valve (not shown), self-acting thermostatic safety valve (not shown) and overheat sensor (not shown).

In some embodiments the PAHS may be adapted to be fuelled only by gas, i.e. a gas bottle may be coupled or integrated in the PAHS. In these embodiments a tank for other type of fuels than gas is not present and the injection system and burner are limited to the one need for the use of gas. For example as shown a bottle of gas may be directly coupled to the PAHS system for direct use.
In some embodiments the PAHS may comprise one or more safety device as thermoelectric safety valve with themo couple and with bimetal switching system for overheat protection.

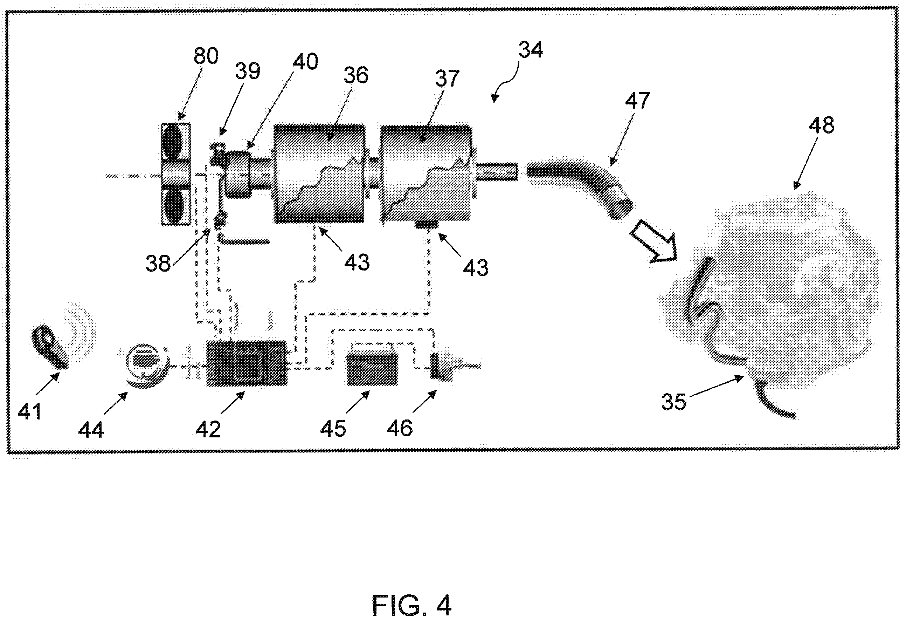

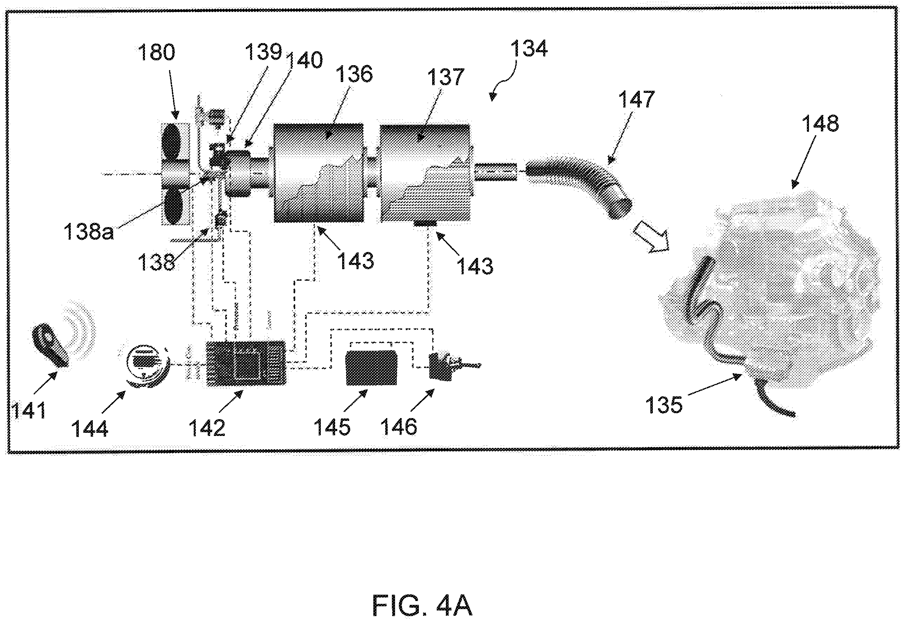

Figure 4 is a schematic drawing of a PAHS 34 according to some embodiments of the invention comprising the third heat exchanger 35.
Figure 4 shows an exploded view drawing of the different components of PAHS 34. The main air fan 80 blows air to be heated towards and through the first heat exchanger 36 and the second heat exchanger 37 so that hot air can be released into the environment in the vicinity of the PAHS 34. Fuel pump 38 and burner air blower 39 feed the burner 40 so as to produce heat as describe in relation to figure 3. The PAHS may be controlled via a remote control 41. A control board 42 may be used to control the operation of the PAHS 34 by combining information provided by the system such as temperature sensors 43 or flame sensors 31 and inputs from the user, e.g. through a thermostat 44. A battery 45, such as a 2.5 AH gel battery may be used for powering the PAHS 34. The battery 45 ensures stand-alone use of the PAHS as may be used to start and stop, e.g. through a switch on/off system 46, the PAHS. As the first heat exchanger produces electricity, the battery can be directly recharged when the PAHS is in operation, thus no need of further electrical power is necessary to operate the PAHS. PAHS 34 further comprises a flexible exhaust connection 47 to connect the system to the third heat exchanger 35. The third heat exchanger 35 is shown as located in the engine 48 of a vehicle. Indeed the third heat exchanger 35 may be used to keep the engine at a temperature few degrees higher than the outside temperature. This further reduces gasoline consumption upon restart of the engine. In general, the PAHS system of the invention may be used in trucks cabin to keep warm a driver who may sleep overnight in the truck cabin. Upon restart of the truck engine, warm up of the engine leads to a high consumption of gasoline while the truck is not moving. By letting the exhaust of the PAHS exchange heat the engine with a heat exchanger located into the engine of the truck, the engine can be kept at a temperature that allows a faster start up and thus leads to the reduction of gasoline consumption.
Figure 4A shows an exploded view drawing of the different components of PAHS 134 according to some embodiments of the invention where a gas can be used as fuel. The main air fan 180 blows air to be heated towards and through the first heat exchanger 136 and the second heat exchanger 137 so that hot air can be released into the environment in the vicinity of the PAHS 134. Liquid fuel pump 138, LPG fuel mixer 138a and burner air blower 139 feed the burner 140 so as to produce heat as describe in relation to figure 3A. The PAHS may be controlled via a remote control 141. A control board 142 may be used to control the operation of the PAHS 134 by combining information provided by the system such as temperature sensors 143 or flame sensors 131 and inputs from the user, e.g. through a thermostat 144. A battery 145, such as a 2.5 AH gel battery may be used for powering the PAHS 134. The battery 135 ensures stand-alone use of the PAHS as may be used to start and stop, e.g. through a switch on/off system 146, the PAHS. As the first heat exchanger produces electricity, the battery can be directly recharged when the PAHS is in operation, thus no need of further electrical power is necessary to operate the PAHS.
PAHS 134 further comprises a flexible exhaust connection 147 to connect the system to the third heat exchanger 135. The third heat exchanger 135 is shown as located in the engine 148 of a vehicle. Indeed the third heat exchanger 135 may be used to keep the engine at a temperature few degrees higher than the outside temperature. This further reduces fuel consumption upon restart of the engine. In general, the PAHS system of the invention may be used in trucks cabin to keep warm a driver who may sleep overnight in the truck cabin. Upon restart of the truck engine, warm up of the engine leads to a high consumption of gasoline while the truck is not moving. By letting the exhaust of the PAHS exchange heat the engine with a heat exchanger located into the engine of the truck, the engine can be kept at a temperature that allows a faster start up and thus leads to the reduction of fuel consumption, whether the fuel used is in the liquid or gas form. In some embodiments, where the PAHS is adapted to be fuelled only by gas an additional battery, such as battery 145, may not be needed as the starting of the burner may be achieved without the need of electricity.

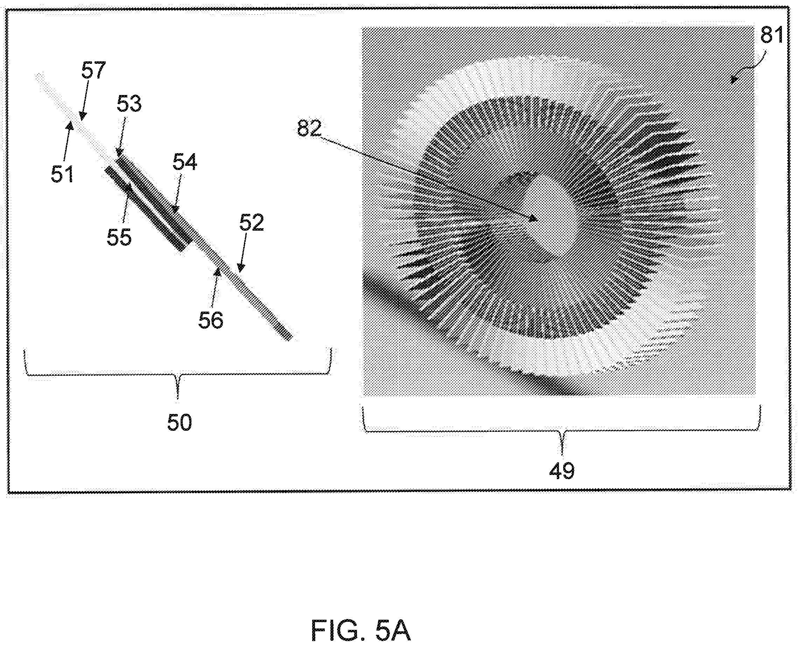

Figure 5A is a schematic view of the first air cooled heat exchanger 81 according to some embodiments of the invention.
The first heat exchanger, which is also the power generator of the system, may be produced by assembling single rings 49 produced by building and assembling components 50 together.
Each component 50 comprises at least an air cooled element 51 a heat element 52 and thermoelectric square slices or modules 53 located in between and in contact with the air cooled element 51 and the heat element 52.
When in operation the heat elements are heated by the passage of hot air, exhaust and flame produced by the burner into the burner pipe or combustion chamber 82 in contact with a portion of the heat elements 52. Air cooled elements 51 are cooled by the air blowing in between the air cooled elements forced in contact with these elements by the main air fan (not shown). The difference in temperature between the air cooled elements 51 and the heat elements 52 triggers the generation of electricity from the thermoelectric square slices or modules 53 located in between the air cooled elements 51 and the heat elements 52.
The single ring shape 49 is achieved through the design of its components 50. In each component 50 the heat elements 52 and the air cooled elements 51 have the portions 54 and 55, respectively, in contact with the thermoelectric square slices or modules 53 having an inclination in the range between 1 and 45 degrees in respect to a surface of another portion 56 and 57 respectively of the heat elements 52 and of the air cooled elements 51. The portion 56 and 57 are the one not in contact with the thermoelectric square slices or modules 53. The inclination of portion 54 is complementary to the inclination of portion 55. As the thermoelectric square slices or modules 53 have straight and not inclined surfaces, the inclination of portions 54 and 55 of the elements allows for the formation of curved components 50 that can be assembled in circular heat exchanger 49.

In particular, when the thermoelectric module is a square slices, p and n square slice may be alternated between air cooled elements 51 and heat elements 52. For example in the configuration shown in figure 5A air cooled element 51 may be in between a P component, such as a P square slice 53 and a N component, such as a N square slice 53 with the configuration heat element 52/N square slice 53/air cooled element 51/P square slice 53/heat element 52.
The number of rings may be optimized taking in consideration:
- the maximal heat input into the heat exchanger centre duct;
- the maximal heat exchanging efficiency by fully load;
- the electrical power efficiency, e.g. of about 7-8%, of moved heat by air flow over the outer fins;
- the maximal necessary electrical power for running the system, increased by at least 10% for charging the battery when the system is liquid fueled and 30% when the system is Gas (LPG) fueld.

Figure 5B is a schematic view of the first air cooled heat exchanger 358 according to some embodiments of the invention. Figure 5B shows a side view 359 and a cross section 360 of the first air cooled heat exchanger 358. The first air cooled heat exchanger 358 comprises a body comprising air cooled parts surrounding at least part of an inner tube.
In operation combusted fuel and air from the burner outlet will be fed to the inlet 361 of the first heat exchanger 358. The combusted hot gas will flow into the inner tube leading towards the outlet/exhaust tube 366, passing thorugh the inner tube surrounded by the air cooled parts.
Thermoelectrics modules 362 are located on the external surface of the inner tube in between air cooled elements and the external surface of the inner tube.
The air cooled parts of the heat exchanger 358 may be produced through aluminum extruding processes.

Figure 6 is a schematic view of the second air cooled heat exchanger 58 according to some embodiments of the invention. Figure 6 shows a side view 59 and a cross section 60 of the second air cooled heat exchanger 58.
Figure 7 is a cross section of the view 59 of the air cooled heat exchanger 58 of figure 6 according to some embodiments of the invention.

In operation combusted fuel and air from the first heat exchanger will be fed to the inlet 61 of the second heat exchanger 58. The combusted hot gas will flow into the inner tube 62, then swirl back through the gap between the inner tube 62 and outer tube 64 and then turn again forward through the gap between the outer tube 64 and heat exchanger body 65, leading towards the outlet/exhaust tube 66. The second heat exchanger approximately may transfer 80% of the heat entering the heat exchanger 58 through inlet 61.
Heat exchanger 58 may be produced through aluminum extruding processes. Due to the lower combustion temperature in the second heat exchanger, the wall thickness of heat exchanger body 65 may be less than 3mm.

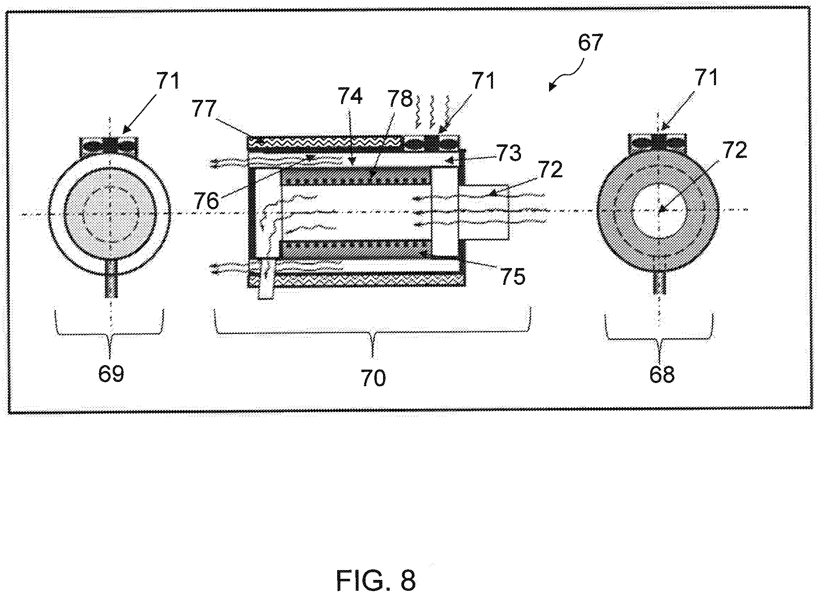

Figure 8 shows different views and cross sections of a flue gas heat exchanger 67 according to some embodiments of the invention.
The third heat exchanger 67, e.g. when the PAHS is mounted on a vehicle or on a boat, of figure 8 shows a front view 68, a back view 69 and a longitudinal cross section 70 of the third heat exchanger 67. The heat exchanger 67 is meant to be mounted close to an engine oil pan with the function of keeping the engine body and the engine oil warm during the period of rest of the engine.
This heat exchanger 67 has a flue gas power generator for powering a fan 71.
In operation a flow of exhaust gas /flue gas, from the second heat exchanger through an insulated flexible stainless steel tube, enters the heat exchanger 67 thought the inlet tube 72.
The heat exchanger 67 is a double tube with a gap 73 between the outer wall 74 of inner tube 75 and inner wall 76 of outer tube 77. The air blown by the fan 71 through gap 73 cools down the outer surface 74 of inner tube 75. The inner tube works as a thermoelectric generator as it contains thermoelectric modules 78 powering the fan 71. The fan 71 continually send the cold air to the third heat exchanger, thus the air is heated and the warm air is blown to the oil pan of the engine. Means for transferring heat, such as metal capes, may be present to transfer heat from the thermoelectric modules to the outer surface 74 of the inner tube 75. By removing the heat from the exhaust gases, there will be condensation inside the inner tube, which will drop out from the exhaust drain tube. Thus, the third heat exchanger is made of materials resistant to acid environments.

### Operational procedures

The PAHS unit is started by switching it to ON position, thus the electronic control starts the fan for few seconds. After few seconds the control board registers the temperature at the inlet. If the temperature is below the set point, e.g. adjusted by the heater thermostat, the start-up procedure begins. Start-up occurs by powering the glow wire mesh for liquid fuel or spark plug for LPG fuel. Hereafter, the heater runs and the first heat exchanger starts producing electrical power that will be sent to the battery. The battery provides power for all the components that need electrical power. After less than a minute from start time the battery will be charged and the surplus electrical power is available for external use.
When the temperature at the air inlet overcome the thermostat set point, the fuel pump stops injecting fuel in the burner for liquid fuel or the fuel valve close the fuel tube inlet for LPG fuel and the burner stop while the fan is still running until the temperature of the second heat exchanger reaches a value below the thermostat set point.

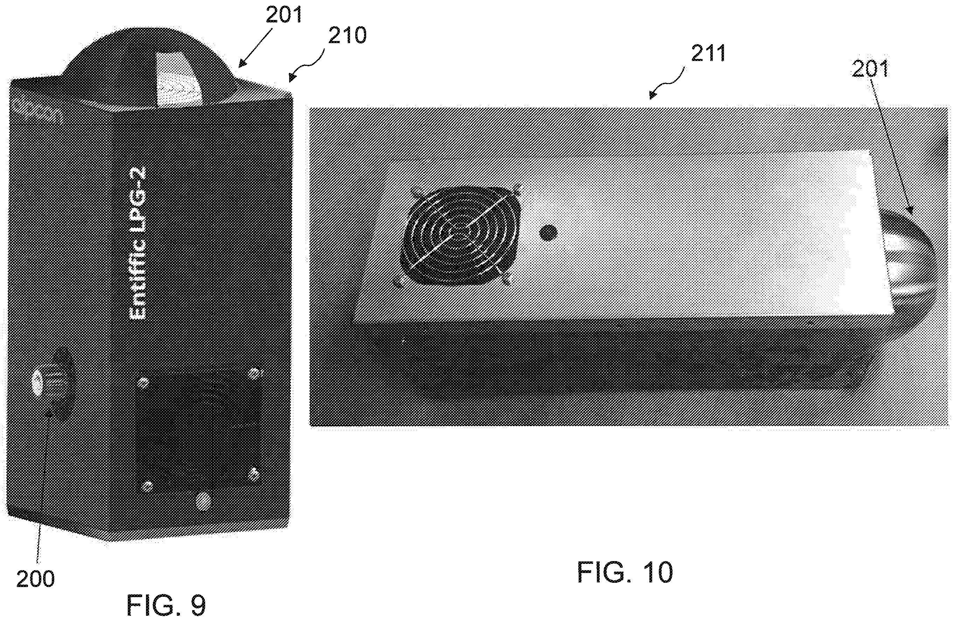

Figure 9 and 10 show a schematic drawing of PAHS designed to be used in different positions.
Figure 9 shows a schematic drawing of PAHS 210 designed to be used in a standing position. Figure 9 shows also a knob 200 for regulation of the PAHS. The PAHS 210 may comprise an handle, such as a flexible handle (not shown) that allows for carrying the PAHS 210.
Figure 10 shows a schematic drawing of PAHS 211 designed to be used in its lying, ie. orizontal position.

In some example the PAHS could be also used for heating materials located onto the air outlet of the PAHS.
For example a metallic semipherical top container, similar to the metallic semipherical top container 201 shown in figure 9 and 10, can be removed from its position, turned and fasten in the opposite position so as to provide a concave surface that is heated by the hot air blowing underneath the surface.

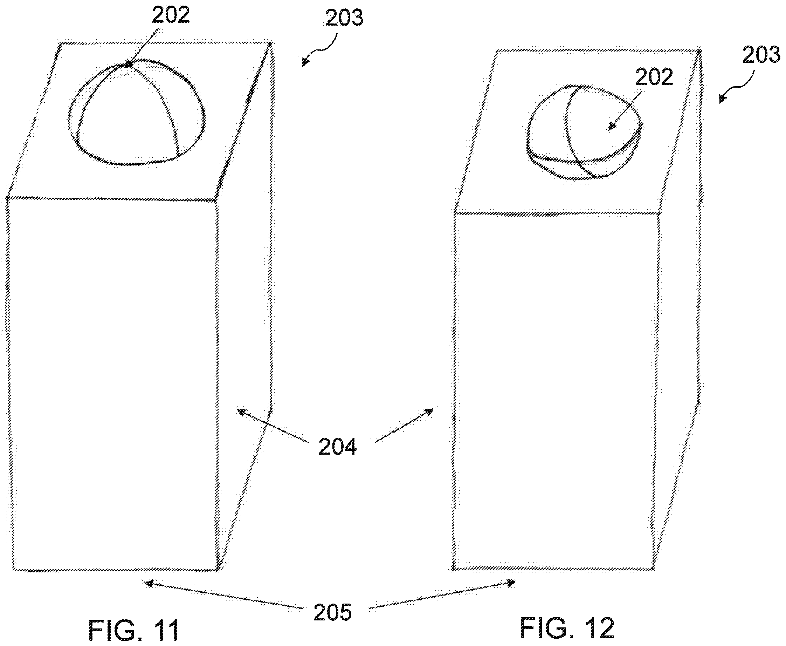

Figure 11 and 12 show a PAHS 203 adapted to be used for heating materials, such as cooking food. The convex metallic semipherical top 202 of the PAHS 203 as shown in figure 11, can be removed, turned and fasten in the opposite position in the cavity left open on the same PAHS 203 as shown in figure 12, thus providing a concave surface that can be used for heating food when the PAHS is in operation. These embodiments take advantage of the use of a standard gas bottle that can be easily couple at the bottom 205 or on the side 204 of the PAHS 203. The gas bottle in these or other embodiments may be at least partially contained in the PAHS 203.

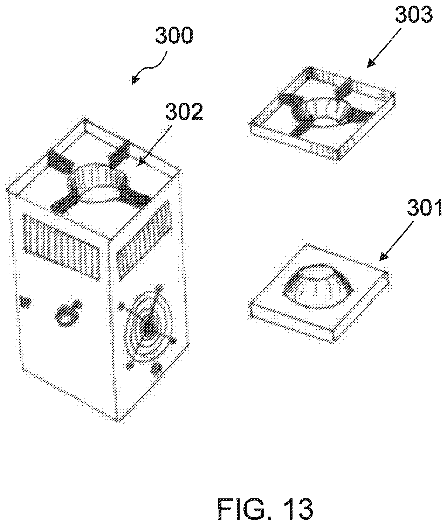

Figure 13 shows a PAHS 300 adapted to be used for heating materials, such as cooking food, according to some embodiments.

The over cap 301 is located onto the top area 302 of the PAHS 300 when the PAHS 300 is used for air heating. When the PAHS 300 is used for cooking food, the over cap 301 can be removed and turned showing the bottom surface 303 of the over cap 301 adapted to be placed onto the top area 302. Thus the bottom surface 303 providies a concave surface heated from the below flow of hot air which can be used for food heating.
In some examples, the removal of the over cap 301 allows for direct use for cooking food as the top area 302 is adapted for this use, i.e. includes structures that can be directly used for cooking food inside or outside a container.

## Claims

1. A portable air heating system (PAHS) (1, 10, 34, 110, 134, 203, 210, 211, 300, 301), comprising:
- a PAHS air inlet (2, 302) ;
- a burner (3, 24, 40, 140, 303) connected to said air inlet, said burner comprising a fuel inlet for introducing fuel to said burner, a combustion blower for blowing air from an air inlet into said burner, thereby allowing for combustion of said fuel, and a burner air outlet for releasing heated air;
- a first heat exchanger (5, 15, 36, 115, 136, 305, 358) for producing electricity, wherein said first heat exchanger is a thermoelectric power generator comprising thermoelectric modules, wherein heat is exchanged between said heated air and elements of said first heat exchanger; wherein said first heat exchanger comprises a first heat exchanger air inlet tube for heated air, said first heat exchanger air inlet tube connected to said burner air outlet, a first heat exchanger air outlet tube and a first heat exchanger body; wherein said first heat exchanger body is located around said burner air outlet or around said first heat exchanger air inlet tube; wherein said first heat exchanger body comprises air cooled elements (51), heat elements (52); and said thermoelectric modules located in between and in contact with said air cooled elements and said heat elements, thereby producing electricity when in operation; and wherein said heat elements (52) and said air cooled elements (51) have a first portion (54, 55) in contact with at least one of said thermoelectric modules (53) wherein a surface of said first portion (55, 54) in contact with said at least one of said thermoelectric modules (53) has an inclination in the range between 1 and 45 degrees in respect to a surface of a second portion (56, 57) of said heat elements (52) and of said air cooled elements (51);
and wherein said first heat exchanger consists of assembled single rings (49) of built and assembled components (50), wherein each component (50) comprises at least said air cooled element (51), said heat element (52) and said thermoelectric square modules (53) located in between and in contact with said air cooled element (51) and said heat element (52);
- a second heat exchanger (6, 16, 37, 58, 116, 137) for increasing the temperature of air entering said PAHS air inlet; and;
- means for blowing air from said PAHS air inlet towards said first heat exchanger; wherein said means for blowing air from said PAHS air inlet towards said first heat exchanger are means for blowing air from said PAHS air inlet towards said first heat exchanger and second heat exchanger.

2. A PAHS according to claim 1 wherein said inclination of said first portion of said heat elements is complementary to said inclination of said first portion of said air cooled elements.

3. A PAHS according to any of the preceding claims wherein said second heat exchanger comprises:
- a second heat exchanger air inlet tube for heated air, said second heat exchanger air inlet tube connected to said first heat exchanger air outlet tube;
- a body comprising air cooled parts said body surrounding at least part of said second heat exchanger air inlet tube for heated air; and
- a second heat exchanger air outlet tube.

4. A PAHS according to claim 3 wherein said body of said second heat exchanger further comprises at least an open chamber surrounding at least part of said second heat exchanger air inlet tube.

5. A PAHS according to any of claims 3 and 4, wherein said body of said second heat exchanger is configured so that the air entering the second heat exchanger air inlet tube is forced through a confined space between an internal surface of said at least one open chamber and an external surface of said second heat exchanger air inlet tube.

6. A PAHS according to any of the preceding claims wherein said second heat exchanger is located downstream to said first heat exchanger.

7. A PAHS according to any of the preceding claims further comprising: a third heat exchanger for producing electricity, said third heat exchanger connected to said second heat exchanger, wherein said third heat exchanger is a flue gas tube for generation of thermoelectric power, said flue gas tube comprising:
- an inner portion having an internal and external surface, said inner portion having thermoelectric modules located on said external surface;
- an outer portion having an internal and external surface, said outer portion surrounding said inner portion;
- means for transferring heat between said thermoelectric modules and said outer portion.

8. A PAHS according to claim 7 adapted to be inserted in a vehicle engine.

9. A PAHS according to any of the preceding claims 1-8 further comprising a fuel tank.

10. A PAHS according to claim 9 wherein said fuel tank is physically connected to said PAHS.

11. A PAHS according to any of the claims 9-10 wherein said fuel tank is gas bottle, such as a LPG bottle.

## Patentansprüche

1. Ein tragbares Luftheizungssystem (TLHS) (1, 10, 34, 110, 134, 203, 210, 211, 300, 301), das aufweist:
- einen TLHS-Lufteinlass (2, 302);
- einen Brenner (3, 24, 40, 140, 303), der mit dem Lufteinlass verbunden ist, wobei der Brenner einen Kraftstoffeinlass zum Einleiten von Kraftstoff in den Brenner, ein Verbrennungsgebläse zum Blasen von Luft von einem Lufteingang in den Brenner, um dadurch die Verbrennung des Kraftstoffs zu erlauben, und einen Brenner-Luftauslass zum Herauslassen von erhitzter Luft aufweist;
- einen ersten Wärmetauscher (5, 15, 36, 115, 136, 305, 358) zum Erzeugen von Elektrizität, wobei der erste Wärmetauscher ein thermoelektrischer Leistungsgenerator ist, der thermoelektrische Module aufweist, wobei Wärme getauscht wird zwischen der erwärmten Luft und Elementen des ersten Wärmetauschers; wobei der erste Wärmetauscher einen ersten Wärmetauscher-Lufteinlasskanal für erhitzte Luft, wobei der erste Wärmetauscher-Lufteinlasskanal mit dem Brenner-Luftauslass verbunden ist, einen ersten Wärmetauscher-Luftauslasskanal und einen ersten Wärmetauscherkörper aufweist; wobei der erste Wärmetauscherkörper um den Brenner-Luftauslass oder um den ersten Wärmetauscher-Lufteinlasskanal angeordnet ist; wobei der erste Wärmetauscherkörper luftgekühlte Elemente (51), Heizelemente (52) aufweist; und die thermoelektrischen Module, sind zwischen und in Kontakt mit den luftgekühlten Elementen und den Heizelementen angeordnet, um dadurch im Betrieb Elektrizität zu produzieren; und wobei die Heizelemente (52) und die luftgekühlten Elemente (51) einen ersten Abschnitt (54, 55) in Kontakt mit zumindest einem der thermoelektrischen Module (53) haben, wobei eine Oberfläche des ersten Abschnitts (55, 54) in Kontakt mit dem mindestens einen der thermoelektrischen Module (53) eine Neigung im Bereich zwischen 1 und 45° in Bezug auf eine Oberfläche eines zweiten Abschnitts (56, 57), der Heizelemente (52) und der luftgekühlten Elemente (51) hat;
- und wobei der erste Wärmetauscher aus zusammengebauten einzelnen Ringen (49) von gebauten und zusammengebauten Komponenten (50) besteht, wobei jede Komponente (50) mindestens ein luftgekühltes Element (51), das Heizelement (52) und die thermoelektrischen Rechteckmodule (53) aufweist, die zwischen und in Kontakt mit dem luftgekühlten Element (51) und dem Heizelement (52) angeordnet sind;
- einen zweiten Wärmetauscher (6, 16, 37, 58, 116, 137) zur Erhöhung der Temperatur von Luft, die in den TLHS-Lufteinlass eintritt; und
- Mittel zum Blasen von Luft von dem TLHS-Lufteinlass in Richtung auf den ersten Wärmetauscher; wobei die Mittel zum Blasen von Luft von dem TLHS-Lufteinlass in Richtung auf den ersten Wärmetauscher Mittel sind zum Blasen von Luft von dem TLHS-Lufteinlass in Richtung auf den ersten Wärmetauscher und zweiten Wärmetauscher.

2. Ein TLHS nach Anspruch 1, wobei die Neigung des ersten Abschnitts der Heizelemente komplementär zu der Neigung des ersten Abschnitts der luftgekühlten Elemente ist.

3. Ein TLHS nach einem der vorangehenden Ansprüche, wobei der zweite Wärmetauscher aufweist:
- einen zweiten Wärmetauscher-Lufteinlasskanal für erhitzte Luft, wobei der zweite Wärmetauscher-Lufteinlasskanal verbunden ist mit dem ersten Wärmetauscher-Luftauslasskanal;
- einen Körper, der luftgekühlte Teile aufweist, wobei der Körper mindestens Teil des zweiten Wärmetauscher-Lufteinlasskanals für erhitzte Luft umgibt; und
- einen zweiten Wärmetauscher-Luftauslasskanal.

4. Ein TLHS nach Anspruch 3, wobei der Körper des zweiten Wärmetauschers weiterhin aufweist mindestens eine offene Kammer, die zumindest Teil des zweiten Wärmetauscher-Lufteinlasskanals umgibt.

5. Ein TLHS nach Anspruch 3 oder 4, wobei der Körper des zweiten Wärmetauschers so ausgebildet ist, dass die Luft, die in den zweiten Wärmetauscher-Lufteinlasskanal eintritt, durch einen begrenzten Raum zwischen einer inneren Oberfläche der mindestens einer offenen Kammer und einer äußeren Oberfläche des zweiten Wärmetauscher-Lufteinlasskanal gezwungen wird.

6. Ein TLHS nach einem der vorangehenden Ansprüche, wobei der zweite Wärmetauscher stromab zu dem ersten Wärmetauscher angeordnet ist.

7. Ein TLHS nach irgendeinem der vorangehenden Ansprüche, das weiterhin aufweist: einen dritten Wärmetauscher zum Erzeugen von Elektrizität, wobei der dritte Wärmetauscher mit dem zweiten Wärmetauscher verbunden ist, wobei der dritte Wärmetauscher ein Rauchgaskanal ist für die Erzeugung von thermoelektrischer Leistung, wobei der Rauchgaskanal aufweist:
- einen inneren Abschnitt, der eine innere und eine äußere Oberfläche aufweist, wobei der innere Abschnitt thermoelektrische Module aufweist, die auf der äußeren Oberfläche angeordnet sind;
- einen äußeren Abschnitt mit einer inneren und äußeren Oberfläche, wobei,der äußere Abschnitt den inneren Abschnitt umgibt;
- Mittel zum Übertragen von Wärme zwischen den thermoelektrischen Modulen und dem äußeren Abschnitt.

8. Ein TLHS nach Anspruch 7, der geeignet ist, um in einen Fahrzeugmotor eingebaut zu werden.

9. Ein TLHS nach irgendeinem der vorangehenden Ansprüche 1 bis 8, das weiterhin einen Kraftstofftank aufweist.

10. Ein TLHS nach Anspruch 9, worin der Kraftstofftank physikalisch mit dem TLHS verbunden ist.

11. Ein TLHS nach irgendeinem der Ansprüche 1 bis 10, worin der Kraftstofftank eine Gasflasche ist, z.B. eine Flüssiggasflasche.

## Revendications

1. Système de chauffage d'air portatif (SCAP) (1, 10, 34, 110, 134, 203, 210, 211, 300, 301), comprenant :
- une entrée d'air du SCAP (2, 302) ;
- un brûleur (3, 24, 40, 140, 303) connecté à ladite entrée d'air, ledit brûleur comprenant une entrée de combustible pour introduire un combustible audit brûleur, une soufflante de combustion pour souffler de l'air depuis une entrée d'air vers ledit brûleur, permettant ainsi une combustion dudit combustible, et une sortie d'air de brûleur pour dégager de l'air chauffé ;
- un premier échangeur de chaleur (5, 15, 36, 115, 136, 305, 358) pour produire de l'électricité, dans lequel ledit premier échangeur de chaleur est un générateur de puissance thermoélectrique comprenant des modules thermoélectriques, dans lequel de la chaleur est échangée entre ledit air chauffé et des éléments dudit premier échangeur de chaleur ; dans lequel ledit premier échangeur de chaleur comprend un tube d'entrée d'air pour premier échangeur de chaleur destiné à de l'air chauffé, ledit tube d'entrée d'air pour premier échangeur de chaleur étant connecté à ladite sortie d'air du brûleur, à un tube de sortie d'air du premier échangeur de chaleur et à un corps du premier échangeur de chaleur ; dans lequel ledit corps du premier échangeur de chaleur est situé autour de ladite sortie du brûleur ou autour dudit tube d'entrée d'air pour premier échangeur de chaleur ; dans lequel ledit corps du premier échangeur de chaleur comprend des éléments refroidis à l'air (51), des éléments chauffants (52) ; et lesdits modules thermoélectriques étant situés entre et en contact avec lesdits éléments refroidis à l'air et lesdits éléments chauffants, en produisant ainsi de l'électricité en fonctionnement ; et dans lequel lesdits éléments chauffants (52) et lesdits éléments refroidis à l'air (51) ont une première portion (54, 55) en contact avec l'un au moins desdits modules thermoélectriques (53), dans lequel une surface de ladite première portion (55, 54) en contact avec ledit au moins un desdits modules thermoélectriques (53) a une inclinaison dans la plage entre 1 et 45° par rapport à une surface d'une seconde portion (56, 57) desdits éléments chauffants (52) et desdits éléments refroidis à l'air (51) ;
et dans lequel ledit premier échangeur de chaleur est constitué de bagues uniques assemblées (49) formées de composants construits et assemblés (50), dans lequel chaque composant (50) comprend au moins ledit élément refroidi à l'air (51), ledit élément chauffant (52) et lesdits modules thermoélectriques carrés (53) situés entre et en contact avec ledit élément refroidi à l'air (51) et ledit élément chauffant (52) ;
- un second échangeur de chaleur (6, 16, 37, 58, 116, 137) pour augmenter la température de l'air entrant dans ladite entrée d'air du SCAP ; et
- un moyen pour souffler l'air depuis ladite entrée d'air du SCAP vers ledit premier échangeur de chaleur ; dans lequel ledit moyen pour souffler de l'air depuis ladite entrée d'air du SCAP vers ledit premier échangeur de chaleur est un moyen pour souffler de l'air depuis ladite entrée d'air du SCAP vers ledit premier échangeur de chaleur et ledit second échangeur de chaleur.

2. SCAP selon la revendication 1, dans lequel ladite inclinaison de ladite première portion desdits éléments chauffants est complémentaire de ladite inclinaison de ladite première portion desdits éléments refroidis à l'air.

3. SCAP selon l'une quelconque des revendications précédentes, dans lequel ledit second échangeur de chaleur comprend :
- un tube d'entrée d'air pour second échangeur de chaleur destiné à l'air chauffé, ledit tube d'entrée d'air pour second échangeur de chaleur étant connecté audit tube de sortie d'air pour premier échangeur de chaleur ;
- un corps comprenant des parties refroidies à l'air, ledit corps entourant au moins une partie dudit tube d'entrée d'air pour second échangeur de chaleur destiné à de l'air chauffé ; et
- un tube de sortie d'air pour second échangeur de chaleur.

4. SCAP selon la revendication 3, dans lequel ledit corps du second échangeur de chaleur comprend en outre au moins une chambre ouverte qui entoure au moins une partie dudit tube d'entrée d'air pour second échangeur de chaleur.

5. SCAP selon l'une quelconque des revendications 3 et 4, dans lequel ledit corps dudit second échangeur de chaleur est configuré de telle façon que l'air entrant dans le tube d'entrée d'air pour second échangeur de chaleur est forcé à travers un espace confiné entre une surface interne de ladite au moins une chambre ouverte et une surface externe dudit tube d'entrée d'air pour second échangeur de chaleur.

6. SCAP selon l'une quelconque des revendications précédentes, dans lequel ledit second échangeur de chaleur est situé en aval dudit premier échangeur de chaleur.

7. SCAP selon l'une quelconque des revendications précédentes, comprenant en outre : un troisième échangeur de chaleur pour produire de l'électricité, ledit troisième échangeur de chaleur étant connecté audit second échangeur de chaleur, dans lequel ledit troisième échangeur de chaleur est un tube de gaz de combustion pour la génération de puissance thermoélectrique, ledit tube de gaz de combustion comprenant :
- une portion intérieure ayant une surface interne et une surface externe, ladite portion intérieure ayant des modules thermoélectriques placés sur ladite surface externe ;
- une portion extérieure ayant une surface interne et une surface externe, ladite portion extérieure entourant ladite portion intérieure ;
- un moyen pour transférer de la chaleur entre lesdits modules thermoélectriques et ladite portion extérieure.

8. SCAP selon la revendication 7, adapté à être introduit dans un moteur de véhicule.

9. SCAP selon l'une quelconque des revendications précédentes 1 à 8, comprenant en outre un réservoir de combustible.

10. SCAP selon la revendication 9, dans lequel ledit réservoir de combustible est connecté physiquement audit SCAP.

11. SCAP selon l'une quelconque des revendications 9 à 10, dans lequel ledit réservoir de combustible est une bouteille de gaz, comme une bouteille de gaz de pétrole liquéfié.
